# EUROPÄISCHE PATENTANMELDUNG

(11) **EP 3 995 839 A1**
(43) Veröffentlichungstag der Anmeldung: **11.05.2022**
(21) Anmeldenummer: 21020473.1
(22) Anmeldetag: 22.09.2021
(51) Int. Cl.: G01R 15/20

(54) **VERFAHREN ZUR STROMMESSUNG UND MESSVORRICHTUNG**

(30) Priorität: 05.11.2020 DE 102020129127
(71) Anmelder: Dr. Ing. h.c. F. Porsche AG, 70435 Stuttgart (DE)
(72) Erfinder: Simon, Daniel, 71638 Ludwigsburg (DE); Lill, Sven, 74348 Lauffen (DE); Schöffler, Harald, 74626 Bretzfeld-Rappach (DE)

(57) **Zusammenfassung**

Eine Messvorrichtung (20) hat einen Stromsensor (30) und mindestens einen A/D-Wandler (39), welcher Stromsensor (30) mindestens zwei Kanäle (CH1, CH2) aufweist, über welche Kanäle (CH1, CH2) der Stromsensor (30) jeweils ein den Strom (14) charakterisierendes Messsignal (CH1_SIG, CH2_SIG) liefert, welche mindestens zwei Kanäle (CH1, CH2) einen ersten Kanal (CH1) und einen zweiten Kanal (CH2) umfassen, welcher zweite Kanal (CH2) zur Messung eines größeren Maximalstroms ausgebildet ist als der erste Kanal (CH1). Das Verfahren zur Messung eines durch einen Leiter (12) fließenden Stroms (14) mittels der Messvorrichtung (20) weist die folgenden Schritte auf:
A1) Das Messsignal (CH1_SIG) des ersten Kanals (CH1) wird in einer ersten Signalverarbeitungsvorrichtung (40A) verarbeitet, und es wird unter Bildung eines Gütekriteriums (CH1_OOR) ein erster gemittelter Messwert (CH1_AVE) erzeugt,
A2) das Messsignal (CH2_SIG) des zweiten Kanals (CH2) wird in einer zweiten Signalverarbeitungsvorrichtung (40B) verarbeitet, und es wird unter Bildung eines Gütekriteriums (CH2_OOR) ein zweiter gemittelter Messwert (CH2_AVE) erzeugt, B) es wird in einer Auswahlvorrichtung (46) in Abhängigkeit vom jeweiligen Gütekriterium (CH1_OOR; CH2_OOR) ausgewählt, ob der erste gemittelte Messwert (CH2_AVE) oder der zweite gemittelte Messwert (CH2_AVE) als ausgewählter Messwert (SEL_VAL) verwendet wird.

## Beschreibung

Die Erfindung betrifft ein Verfahren zur Messung eines durch einen Leiter fließenden Stroms und eine Messvorrichtung.

Strommessungen sind in vielen Bereichen erforderlich. Bei Elektrofahrzeugen und Hybridfahrzeugen treten hohe Ströme auf, deren Erfassung zur Bestimmung der elektrischen Leistung und hiervon abhängig auch der Motorleistung erforderlich ist. Zudem ist auch die Höhe niedriger Ströme relevant, da beispielsweise der Ladezustand (engl. SOC = state of charge) über das so genannte Coulomb-Counting ermittelt wird, bei dem hohe und niedrige Ströme möglichst genau erfasst werden müssen, da eine Integration der entnommenen Ströme über die Zeit erfolgt. Im Rennsport treten beispielsweise Maximalströme von bis zu +/- 700 A auf, und das Coulomb-Counting erfolgt auch bei Strömen von +/- 75 A oder niedriger.

Die DE 10 2016 218 049 A1, die US 2015 / 333 498 A, die US 5,466,974 A, die US 2014 / 218 018 A, die WO 2017 / 148 823 A1, die US 2015 / 233 978 A, die US 2017 / 322 237 A, die WO 99 / 60691 A1 und die WO 2019 / 016 822 A1 zeigen verschiedene Sensoren für unterschiedliche Anwendungsbereiche.

Es ist daher eine Aufgabe der Erfindung, ein neues Verfahren zur Messung eines durch einen Leiter fließenden Stroms und eine neue Messvorrichtung bereitzustellen.

Diese Aufgabe wird gelöst durch den Gegenstand des Anspruchs 1.

Eine Messvorrichtung weist einen Stromsensor und mindestens einen A/D-Wandler (Analog/Digital-Wandler) auf, welcher Stromsensor mindestens zwei Kanäle aufweist, über welche Kanäle der Stromsensor jeweils ein den Strom charakterisierendes Messsignal liefert, welche mindestens zwei Kanäle einen ersten Kanal und einen zweiten Kanal umfassen, welcher zweite Kanal zur Messung eines größeren Maximalstroms ausgebildet ist als der erste Kanal.

Ein Verfahren zur Messung eines durch einen Leiter fließenden Stroms mittels einer solchen Messvorrichtung weist die folgenden Schritte auf:
A1) Das Messsignal des ersten Kanals wird in einer ersten Signalverarbeitungsvorrichtung verarbeitet, und es wird ein erster gemittelter Messwert erzeugt,
A2) das Messsignal des zweiten Kanals wird in einer zweiten Signalverarbeitungsvorrichtung verarbeitet, und es wird ein zweiter gemittelter Messwert erzeugt,
   wobei in der ersten Signalverarbeitungsvorrichtung und in der zweiten Signalverarbeitungsvorrichtung jeweils eine Tiefpassfilterung des Messsignals durchgeführt wird, eine A/D-Wandlung zur Erzeugung digitaler Einzelmesswerte durchgeführt wird, eine Beurteilung der Einzelmesswerte unter Bildung eines Gütekriteriums durchgeführt wird, und eine Mittelung der Einzelmesswerte zur Erzeugung eines gemittelten Messwerts durchgeführt wird,
B) es wird in einer Auswahlvorrichtung in Abhängigkeit vom jeweiligen Gütekriterium ausgewählt, ob der erste gemittelte Messwert oder der zweite gemittelte Messwert als ausgewählter Messwert verwendet wird.

Durch die separate Verarbeitung in der ersten Signalverarbeitungsvorrichtung und zweiten Signalverarbeitungsvorrichtung kann die Auswahlvorrichtung die Auswahl auf einer qualitativ besseren Datenbasis durchführen, und dies führt dazu, dass der ausgewählte Messwert einen vergleichsweise geringen Fehler hat. Die Mittelung der Einzelmesswerte ermöglicht zum einen die Verwendung eines A/D-Wandlers mit geringerer Auflösung, da die Auflösung durch die Mittelung erhöht wird, und zum anderen können schnellere A/D-Wandler genutzt werden und damit auch häufiger A/D-Wandlungen durchgeführt werden.

Gemäß einer bevorzugten Ausführungsform werden in der ersten Signalverarbeitungsvorrichtung und in der zweiten Signalverarbeitungsvorrichtung jeweils die Einzelmesswerte oder die gemittelten Messwerte durch eine zugeordnete Korrekturfunktion korrigiert. Diese Korrektur ermöglicht zum einen eine Angleichung, so dass bei gleichem Strom in Bereichen, in denen beide Kanäle eine Stromwandlung durchführen können, vergleichbare Messwerte erzeugt werden. Zum anderen können grundsätzliche Ungenauigkeiten des Stromsensors an den jeweiligen Kanälen zumindest teilweise verringert werden.

Gemäß einer bevorzugten Ausführungsform ist die Korrekturfunktion jeweils abhängig vom Ergebnis mindestens einer mit dem zugeordneten Kanal des konkret verwendeten Stromsensors durchgeführten Probemessung. Durch Probemessungen kann wie bei einer Kalibrierung ermittelt werden, wie stark die Messsignale von dem tatsächlichen Wert abweichen, und diese Abweichung kann durch die Korrekturfunktion verringert werden. Für eine sehr genaue Korrektur kann jeweils eine Kennlinie für die Korrekturfunktion verwendet werden, welche eine Zuordnung des jeweiligen Einzelwerts oder des gemittelten Messwerts zu einer Stromstärke definiert.

Gemäß einer bevorzugten Ausführungsform umfasst die Korrekturfunktion einen Offset und eine Skalierung. Durch diese beiden mathematischen Operationen können eine Verschiebung und eine Skalierung erfolgen, und diese einfachen Operationen ermöglichen bereits eine gute Korrektur.

Gemäß einer bevorzugten Ausführungsform wird in der Auswahlvorrichtung in Abhängigkeit von der Höhe des ersten gemittelten Messwerts oder der Höhe des zweiten gemittelten Messwerts ausgewählt, ob der erste gemittelte Messwert oder der zweite gemittelte Messwert als ausgewählter Messwert verwendet wird. Da beide gemittelten Messwerte zumindest in vorgegebenen Bereichen eine ähnliche Stromstärke anzeigen, kann anhand eines dieser gemittelten Messwerte bestimmt werden, welcher besser geeignet ist.

Gemäß einer bevorzugten Ausführungsform erfolgt der Übergang von der Verwendung des ersten gemittelten Messwerts als ausgewählter Messwert zu einer Verwendung des zweiten gemittelten Messwerts als ausgewählter Messwert bei einem ersten Grenz-Messwert, der Übergang von der Verwendung des zweiten gemittelten Messwerts als ausgewählter Messwert zu einer Verwendung des ersten gemittelten Messwerts als ausgewählter Messwert erfolgt bei einem zweiten Grenz-Messwert, und der erste Grenz-Messwert und der zweite Grenz-Messwert sind unterschiedlich, um eine Hysterese zu bewirken. Durch eine solche Hysterese ist der Verlauf des ausgewählten Messwerts weniger schwankend im Übergangsbereich.

Gemäß einer bevorzugten Ausführungsform entspricht der erste Grenz-Messwert einem vom Betrag her höheren Strom als der zweite Grenz-Messwert.

Gemäß einer bevorzugten Ausführungsform weist die Messvorrichtung einen Temperatursensor auf, und es wird über den Temperatursensor ein Temperatur-Messwert ermittelt, und der ausgewählte Messwert wird in Abhängigkeit von einer vom Temperatur-Messwert abhängigen Temperatur-Kompensations-Funktion verändert, um eine von der aktuellen Temperatur abhängige Beeinflussung des ausgewählten Messwerts zu verringern. Die Temperatur hat insbesondere einen Einfluss auf den A/D-Wandler, aber auch der Stromsensor selbst kann temperaturabhängig sein. Es können natürlich die gemittelten Messwerte aller Kanäle mit einer zugeordneten Temperatur-Kompensations-Funktion korrigiert werden, aber das ist nicht zwingend erforderlich.

Gemäß einer bevorzugten Ausführungsform weist die Messvorrichtung eine Ausgabevorrichtung auf, und der ausgewählte Messwert wird über die Ausgabevorrichtung ausgegeben. Der ausgewählte Messwert kann somit anderen Einheiten zur Verfügung gestellt werden. Dies kann im Push-Verfahren oder im Pull-Verfahren geschehen.

Gemäß einer bevorzugten Ausführungsform ist die Ausgabevorrichtung zur Ausgabe des ausgewählten Messwerts über ein Bus-System ausgebildet, welches Bus-System bevorzugt als CAN-Bus, LIN-Bus, CAN-FD, FlexRay oder Ethernet mit BroadR-Reach ausgebildet ist. Eine Verteilung des ausgewählten Messwerts über ein Bus-System ermöglicht eine Nutzung auch in entfernten Einheiten.

Gemäß einer bevorzugten Ausführungsform wird bei der Beurteilung der Einzelmesswerte unter Bildung des Gütekriteriums überprüft, ob der jeweilige Einzelmesswert vom Betrag her größer ist als ein vorgegebener Maximalwert, und eine Überschreitung des Maximalwerts für das Gütekriterium wird gütevermindernd gewertet. Über eine solche Überprüfung kann erkannt werden, ob der Stromsensor in einem ungünstigen Grenzbereich arbeitet, oder ob eine Fehlverschaltung mit einem Spannungspfad vorliegt.

Gemäß einer bevorzugten Ausführungsform wird bei der Beurteilung der Einzelmesswerte unter Bildung des Gütekriteriums überprüft, ob der jeweilige Einzelmesswert vom Betrag her kleiner ist als ein vorgegebener Minimalwert, und bei welchem eine Unterschreitung des Minimalwerts für das Gütekriterium gütevermindernd gewertet wird. Stromsensoren und allgemein Sensoren arbeiten bei der Messung im unteren Bereich ihres Messbereichs üblicherweise ungenauer, und dies kann berücksichtigt werden.

Gemäß einer bevorzugten Ausführungsform ist der Stromsensor ausgewählt aus der Gruppe bestehend aus:
- direktabbildender Stromsensor (englisch: open-loop transducer), und
- Kompensations-Stromsensor (englisch: closed-loop transducer)
Beim direktabbildenden Stromsensor erfolgt keine geregelte Kompensation, und er kann hierdurch schneller arbeiten. Beim Kompensations-Stromsensor erfolgt dagegen eine Kompensation durch einen Regelvorgang.

Gemäß einer bevorzugten Ausführungsform ist der Stromsensor dazu ausgebildet, die durch den zu messenden Strom erzeugte magnetische Flussdichte zu messen. Dies ermöglicht eine indirekte Messung des Stroms, bei welcher der Stromsensor und der Leiter galvanisch voneinander getrennt sind. Bei derartigen Stromsensoren wird die durch den zu messenden Strom erzeugte magnetische Flussdichte gemessen, insbesondere in einem Luftspalt eines den Leiter mit dem zu messenden Strom umgebenden Rings aus weichmagnetischem Material (englisch: core). Der Ring dient zur Verstärkung der magnetischen Flussdichte im Bereich des Luftspalts. Die Messung der magnetischen Flussdichte erfolgt beispielsweise über einen Hall-Sensor, einen GMR-Sensor (GMR = Giant Magneto Resistance) oder einen TMR-Sensor (TMR = Tunneling Magnetoresistance). Es ist auch möglich, am Leiter einen Shunt vorzusehen und die am Shunt abfallende Spannung zu messen. Diese Messung ist vergleichsweise genau, es entsteht aber zusätzliche Wärme durch den elektrischen Widerstand. Zudem wird der Batterie-Innenwiderstand aus Sicht des gesamten Batteriesystems erhöht, und dies ist ebenfalls nachteilig.

Die Aufgabe wird auch gelöst durch eine Messvorrichtung, welche einen Stromsensor und mindestens einen A/D-Wandler aufweist, welcher Stromsensor mindestens zwei Kanäle aufweist, über welche Kanäle der Stromsensor jeweils ein den Strom charakterisierendes Messsignal liefert, welche mindestens zwei Kanäle einen ersten Kanal und einen zweiten Kanal umfassen, welcher zweite Kanal zur Messung eines größeren Maximalstroms ausgebildet ist als der erste Kanal, und welche Messvorrichtung dazu ausgebildet ist, ein Verfahren nach einem der vorhergehenden Ansprüche auszuführen.

Weitere Einzelheiten und vorteilhafte Weiterbildungen der Erfindung ergeben sich aus den im Folgenden beschriebenen und in den Zeichnungen dargestellten, in keiner Weise als Einschränkung der Erfindung zu verstehenden Ausführungsbeispielen sowie aus den Unteransprüchen. Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Es zeigt:
Fig. 1 in schematischer Darstellung einen elektrischen Leiter und eine Messvorrichtung,
Fig. 2 in schematischer Darstellung den Aufbau der Messvorrichtung,
Fig. 3 in schematischer Darstellung ein Flussdiagramm für eine Routine der Messvorrichtung,
Fig. 4 in schematischer Darstellung ein Flussdiagramm für die Bestimmung von Gütekriterien für unterschiedliche Messungen,
Fig. 5 in schematischer Darstellung ein Flussdiagramm für die Auswahl eines geeigneten Messwerts in Abhängigkeit von Gütekriterien, und
Fig. 6 in schematischer Darstellung ein Flussdiagramm für eine Hysteresefunktion.

Im Folgenden sind gleiche oder gleichwirkende Teile mit den gleichen Bezugszeichen versehen und werden üblicherweise nur einmal beschrieben. Die Beschreibung ist figurenübergreifend aufeinander aufbauend, um unnötige Wiederholungen zu vermeiden.

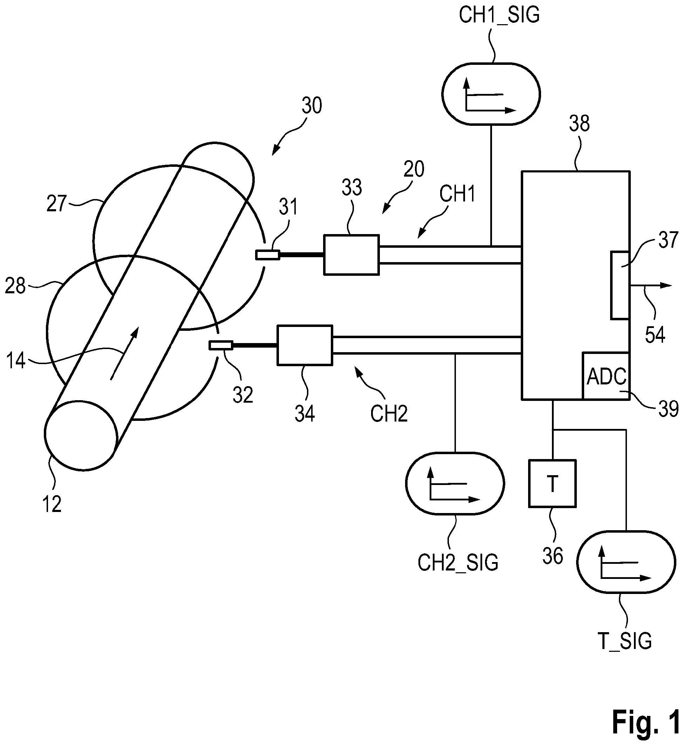

**Fig. 1** zeigt einen Leiter 12, durch den ein Strom 14 fließt. Eine Messvorrichtung 20 ist vorgesehen, und die Messvorrichtung 20 hat einen Stromsensor 30, einen Temperatursensor 36 und eine Auswertevorrichtung 38.

Der Stromsensor 30 ist als galvanisch isolierter Stromsensor ausgebildet, der also nicht galvanisch mit dem Leiter 12 gekoppelt ist. Er weist bevorzugt zwei magnetisch leitende Ringe 27, 28 auf, und in Unterbrechungen dieser magnetisch leitenden Ringe 27, 28, welche auch als Luftspalt bezeichnet werden, ist jeweils ein Flussdichte-Sensor 31, 32 angeordnet, insbesondere ein Hall-Sensor. Die Flussdichte-Sensoren 31, 32 messen die durch den Strom 14 erzeugte magnetische Flussdichte und erzeugen hieraus ein Spannungssignal. Der Stromsensor 30 arbeitet somit als indirekt messender Stromsensor. Das Spannungssignal des Flussdichte-Sensors 31 wird in einer Verstärkungsschaltung 33 verstärkt, und das Spannungssignal des Flussdichte-Sensors 32 wird in einer Verstärkungsschaltung 34 verstärkt. Die Ausgänge der Verstärkungsschaltungen 33 und 34 werden als erster Kanal CH1 und als zweiter Kanal CH2 bezeichnet, und die jeweiligen den Strom 14 charakterisierenden Messsignale CH1_SIG und CH2_SIG werden der Auswertevorrichtung 38 zugeführt.

Es ist nicht erforderlich, zwei magnetisch leitende Ringe 27, 28 vorzusehen, und die Flussdichte-Sensoren 31, 32 können auch im Luftspalt eines einzigen Rings 27 vorgesehen sein und für unterschiedliche Flussdichten optimiert sein.

Der Auswertevorrichtung 38 ist der Temperatursensor 36 zur Erzeugung eines Temperatursignals T_SIG zugeordnet, und sie weist einen A/D-Wandler ADC 39 und eine Ausgabevorrichtung 37 auf, über welche Ausgabevorrichtung 37 die Auswertevorrichtung 38 ein Signal auf einer Leitung 54 ausgeben kann.

Der Temperatursensor 36 ist bevorzugt ein NTC-Temperatursensor oder ein PTC-Temperatursensor, und er ist bevorzugt in der Nähe des A/D-Wandlers ADC 39 angeordnet, um die Temperatur des A/D-Wandlers 39 in guter Näherung bestimmen zu können.

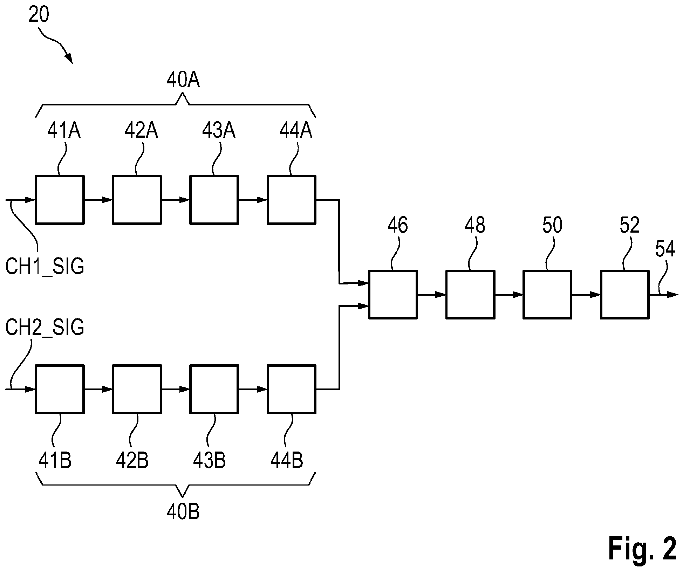

**Fig. 2** zeigt in schematischer Darstellung die in der Messvorrichtung 20 ablaufenden Schritte bzw. die vorhandenen Einheiten/Module.

Das erste Messsignal CH1_SIG des ersten Kanals CH1 wird in einer ersten Signalverarbeitungsvorrichtung 40A verarbeitet, und das zweite Messsignal CH2_SIG wird in einer zweiten Signalverarbeitungsvorrichtung 40B verarbeitet. Die erste Signalverarbeitungsvorrichtung 40A hat vier Einheiten 41A, 42A, 43A, 44A.

In der Einheit 41A wird ein Tiefpass auf das Messsignal CH1_SIG angewandt. Bevorzugt ist der Tiefpass als analoge Schaltung ausgebildet. Der Tiefpass kann beispielsweise vom Typ Sallen-Key-Filter der zweiten Ordnung sein, oder es kann ein einfacher Tiefpass erster Ordnung genutzt werden. Durch die Anwendung des Tiefpasses werden hochfrequente Schwingungen gedämpft, und dies führt zu einem besseren Ergebnis bei einer anschließenden A/D-Wandlung in der Einheit 42A. Der Tiefpass wirkt als Anti-Aliasing Filter und ist vorteilhaft, da hierdurch eine Einhaltung des Nyquist/Shannon-Abtasttheorems realisiert werden kann. Durch die A/D-Wandlung wird das Messsignal CH1_SIG in einen entsprechenden digitalen Einzeimesswert CH1_VAL umgewandelt.

In der Einheit 43A wird aus einer Mehrzahl von gemessenen Einzelmesswerten CH1_VAL ein gemittelter Messwert CH1_AVE berechnet, und es wird eine Beurteilung der Einzelmesswerte CH1_VAL unter Bildung eines Gütekriteriums durchgeführt.

Anschließend wird in der Einheit 44A eine Korrekturfunktion f_COR_CH1 auf den gemittelten Messwert CH1_AVE angewandet. Die Korrekturfunktion f_COR_CH1 enthält beispielsweise eine Offset-Korrektur und eine Skalierung. Die Korrekturfunktion f_COR_CH1 ist bevorzugt abhängig von mindestens einer mit dem zugeordneten Kanal CH1 des konkret verwendeten Stromsensors 30 durchgeführten Probemessung. Die Korrekturfunktion f_COR_CH1 kann auch in Form einer Kennlinie vorgesehen sein.

Der resultierende gemittelte Messwert CH1_AVE wird einer Einheit 46 zugeführt.

In gleicher Weise erfolgt eine Verarbeitung des zweiten Kanals CH2 bzw. des zweiten Messsignals CH2_SIG in der zweiten Signalverarbeitungsvorrichtung 40B, und die Einheiten 41B, 42B, 43B, 44B entsprechend funktional den Einheiten 41A, 42A, 43A und 44A. Die Korrekturfunktion in der Einheit 44B wird als f_COR_CH2 bezeichnet.

Die Einheit 46 ist eine Auswahlvorrichtung, welche in Abhängigkeit vom jeweiligen Gütekriterium auswählt, ob der erste gemittelte Messwert CH1_AVE oder der zweite gemittelte Messwert CH2_AVE als ausgewählter Messwert SEL_VAL verwendet wird.

Bevorzugt wird anschließend in einer Einheit 48 ein Tiefpassfilter angewandt, um die Dynamik des ausgewählten Messwerts SEL_VAL zu begrenzen. Das Filter der Einheit 48 kann jedoch in Abhängigkeit von der konkreten Anwendung bei einer gewünschten hohen Dynamik entfallen.

Anschließend wird in der Einheit 50 eine temperaturabhängige Korrektur des ausgewählten Messwerts SEL_VAL durch Anwendung einer Temperatur-Kompensations-Funktion f_T_COMP durchgeführt, wobei die Temperatur durch den Temperatursensor 36 von Fig. 1 als Messwert vorliegt. Die Temperatur wirkt sich bei der Messung insbesondere auf den A/D-Wandler aus, und dieser Effekt kann durch die Einheit 50 verringert oder kompensiert werden. Auch andere temperaturbedingte Einwirkungen auf die Messung können durch die Temperatur-Kompensations-Funktion f_T_COMP verringert werden.

In der Einheit 52 kann schließlich der ausgewählte Messwert ausgegeben werden, bspw. über einen CAN-Bus oder einen LIN-Bus.

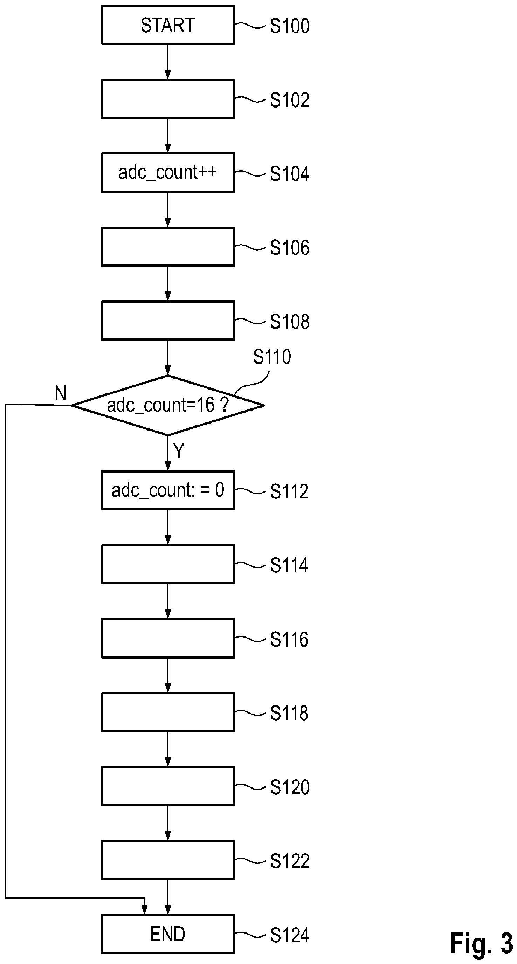

Fig. 3 zeigt ein Flussdiagramm mit Schritten, die jeweils beginnend mit einem Buchstaben S und einer anschließenden Zahl durchnummeriert sind. Eine Routine S100 wird bspw. in regelmäßigen Abständen durch einen Timer-Interrupt oder durch eine Schleife aufgerufen, und es erfolgt ein Sprung nach S102.

In S102 erfolgt über den A/D-Wandler 39 von Fig. 1 eine Wandlung des ersten Messsignals CH1_SIG, eine Wandlung des zweiten Messsignals CH2_SIG und eine Wandlung des vom Temperatursensor 36 von Fig. 1 erzeugten Temperaturmesssignals T_SIG. Sofern mehrere A/D-Wandler 39 vorhanden sind, können die Wandlungen parallel erfolgen. Alternativ kann die A/D-Wandlung nacheinander erfolgen, und Mikrocontroller haben hierzu gegebenenfalls einen dem A/D-Wandler zugeordneten Multiplexer.

Die entsprechenden Einzelmesswerte werden bezeichnet als CH1_VAL, CH2_VAL und T_VAL.

In S104 wird eine variable adc_count inkrementiert, um anzuzeigen, dass eine weitere Messung stattgefunden hat.

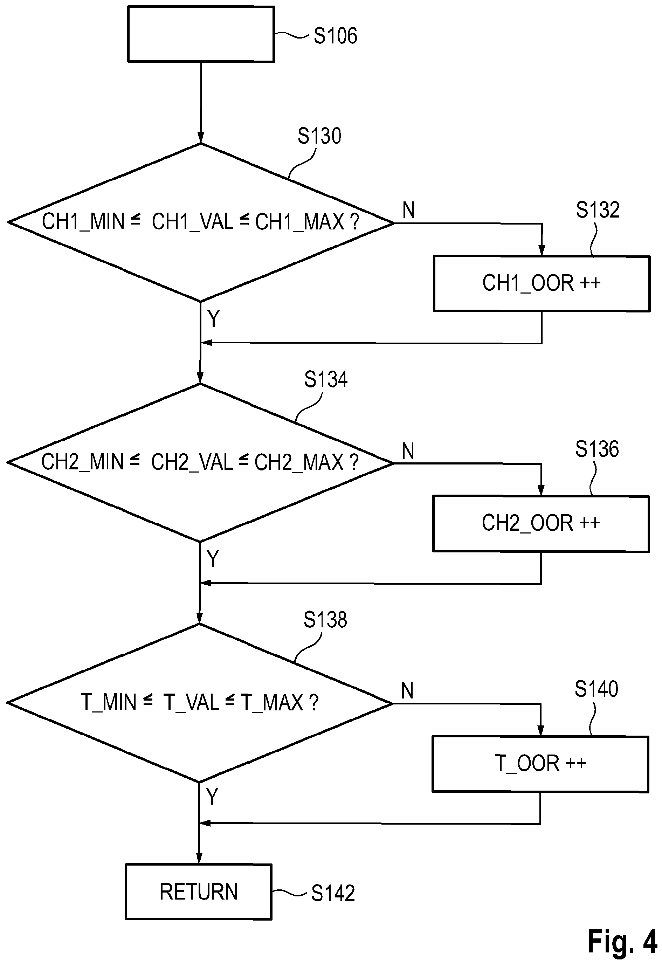

In S106 erfolgt eine Beurteilung der Einzelmesswerte unter Bildung eines Gütekriteriums, welches bspw. als CH1_OOR, CH2_OOR und T_OOR bezeichnet wird. Ein Beispiel für die Erzeugung der Gütekriterien ist in Fig. 4 gezeigt.

In S108 wird eine Summe der bisher ermittelten Einzelmesswerte gebildet.

In S110 wird anschließend überprüft, ob bereits 16 Einzelmesswerte ermittelt wurden. Hierzu wird überprüft, ob die variable adc_count den Wert 16 hat. Im Ausführungsbeispiel werden somit jeweils 16 Messwerte gemittelt. Diese Zahl kann jedoch in Abhängigkeit vom konkreten Ausführungsbeispiel geeignet gewählt werden, beispielsweise 8 oder 20. Falls noch keine 16 Einzelmesswerte ermittelt wurden, erfolgt ein Sprung nach S124, und die Routine wird beendet. Falls jedoch 16 Messungen durchgeführt wurden, erfolgt ein Sprung nach S112, und die Variable adc_count wird zurückgesetzt. Im Schritt S114 werden anschließend die gemittelten Messwerte CH1_AVE des ersten Kanals und CH2_AVE des zweiten Signals durch eine Berechnung mit einem für den jeweiligen Kanal geeignet Offset und mit einer Skalierung versehen, es wird also die in Fig. 2 beschriebene Korrekturfunktion f_COR_CH1 bzw. f_COR_CH2 angewandt.

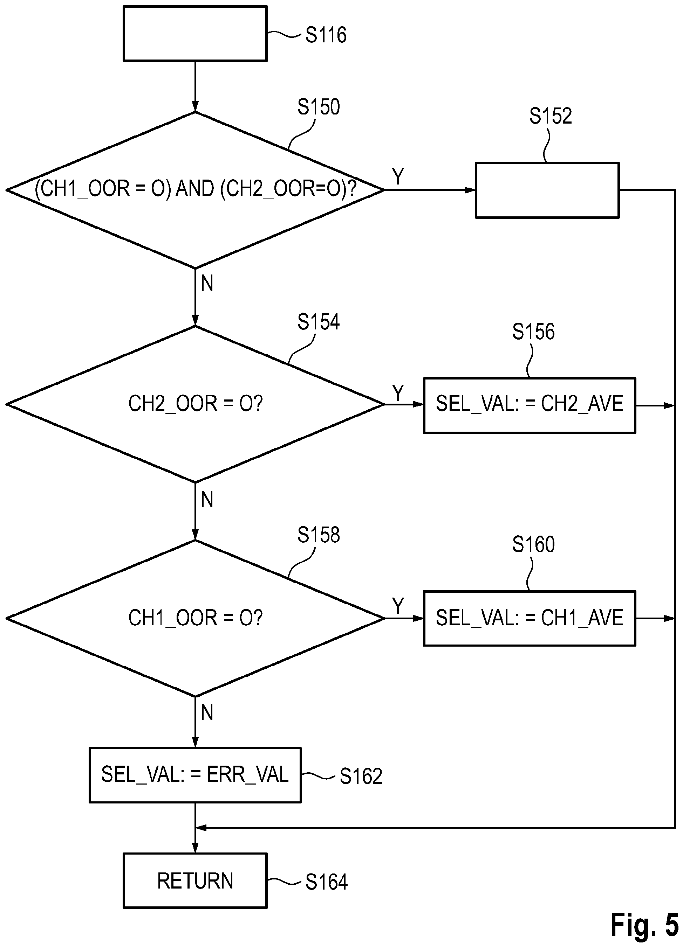

In S116 wird derjenige Kanal ausgewählt, welcher eine höhere Genauigkeit bzw. eine höhere Güte hat. Dies erfolgt in Abhängigkeit von den Gütekriterien, die in Abhängigkeit von den Einzelmesswerten bestimmt wurden. Ein Ausführungsbeispiel für S116 ist in Fig. 5 gezeigt.

In S118 wird ein Tiefpassfilter auf den ausgewählten Messwert SEL_VAL angewandt, und dies entspricht der Einheit 48 von Fig. 2.

In S120 erfolgt eine Ausgabe des ausgewählten Messwerts SEL_VAL.

In S122 wird anschließend die Erzeugung des nachfolgenden gemittelten Messwerts vorbereitet. Hierzu werden insbesondere die Gütekriterien zurückgesetzt, und die Variablen für die Mittelwertbildung werden ebenfalls zurückgesetzt sowie eine Information über den aktuell ausgewählten Kanal CH1 bzw. CH2 gespeichert.

In S124 wird die Routine verlassen.

Die Routine S100 wird wie oben ausgeführt in regelmäßigen Abständen aufgerufen, bspw. mit einer Frequenz von 8 kHz bzw. alle 125 µs.

**Fig. 4** zeigt eine Ausführungsform des Schritts S106 zur Bestimmung der Gütekriterien.

In S130 wird überprüft, ob der Einzelmesswert CH1_VAL des ersten Kanals CH1 zwischen einem Minimalwert CH1_MIN und einem Maximalwert CH1_MAX liegt. Falls dies der Fall ist, ist die Messung in einem geeigneten Bereich, und es erfolgt ein Sprung nach S134. Falls der Einzelmesswert CH1_VAL jedoch außerhalb des vorgegebenen Bereichs ist, erfolgt ein Sprung nach S132, und ein Gütekriterium CH1_OOR wird inkrementiert. Hierdurch wird angezeigt, dass diese Messung in einem nicht geeigneten Bereich liegt. Anschließend erfolgt ein Sprung nach S134. Anhand des Gütekriteriums CH1_OOR kann somit bestimmt werden, ob einer oder mehrere der zu mittelnden Einzelmesswerte außerhalb des zulässigen Bereichs waren. Zu niedrige Messwerte können bspw. durch eine Fehlfunktion entstehen, bei der eine Verbindung zur Masse GND besteht, oder der zu messende Strom ist zu gering für den entsprechenden Kanal. Zu hohe Einzelmesswerte können bspw. bei einer zu hohen Stromstärke auftreten, oder bei einer fehlerhaften Verbindung des Stromsensors 30 mit einer positiven Spannung. Das Gütekriterium CH1_OOR kann natürlich mit feinerer Granularität bestimmt werden, und es kann bspw. gespeichert werden, ob die jeweiligen Werte zu niedrig oder zu hoch waren.

Der Schritt S134 entspricht für den zweiten Kanal CH2 dem Schritt S130 und der Schritt S136 dem Schritt S132. Die entsprechenden Werte sind für den zweiten Kanal CH2 vorgesehen. Der Minimalwert wird CH2_MIN genannt, der Maximalwert CH2_MAX, der Einzelmesswert CH2_VAL und das Gütekriterium CH2_OOR.

In S138 wird eine entsprechende Plausibilitätsprüfung für den Temperaturmesswert T_VAL durchgeführt, und dieser muss sich im Bereich T_MIN bis T_MAX befinden, damit er als gültig angesehen wird. In S140 kann ein entsprechendes Gütekriterium T_OOR für die Temperaturmessung verwendet werden.

In S142 wird die Routine S106 beendet.

**Fig. 5** zeigt ein Ausführungsbeispiel für den Schritt S116 von Fig. 3, in dem ein gemittelter Messwert in Abhängigkeit von den Gütekriterien ausgewählt wird.

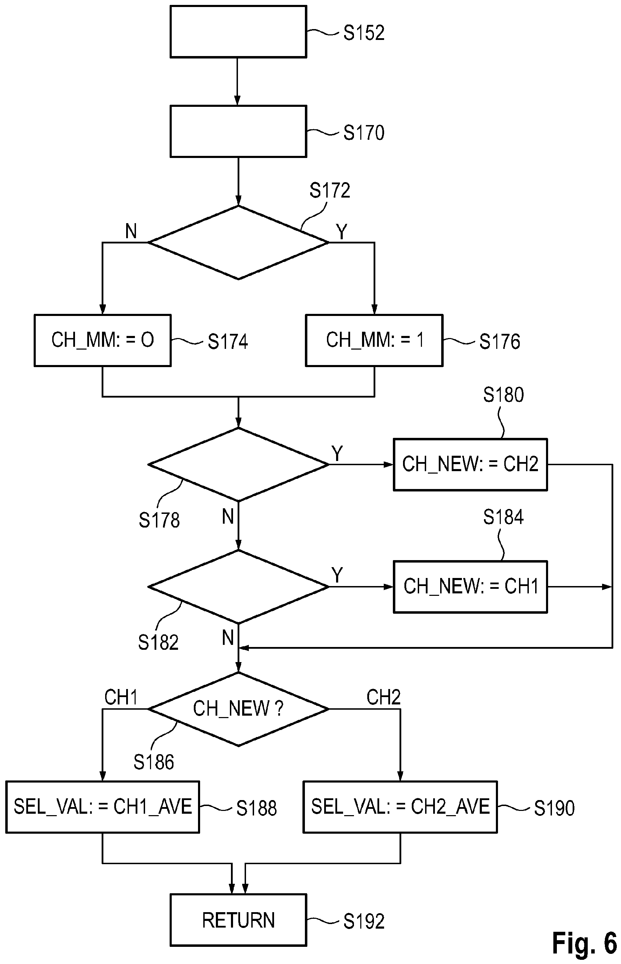

In S150 wird überprüft, ob sowohl beim ersten Kanal CH1 als auch beim zweiten Kanal CH2 alle Einzelmesswerte CH1_VAL bzw. CH2_VAL im jeweils vorgegebenen Bereich lagen. Falls ja, erfolgt in S152 eine Auswahl eines geeigneten gemittelten Messwerts des ersten Kanals oder zweiten Kanals, wie dies in Fig. 6 gezeigt ist.

Wenn jedoch bei mindestens einem Kanal über das zugeordnete Gütekriterium eine nicht geeignete Messung eines Einzelmesswerts CH1_VAL bzw. CH2_VAL angezeigt ist, erfolgt ein Sprung nach S154.

In S154 wird überprüft, ob alle Einzelmesswerte CH2_VAL beim zweiten Kanal CH2 in einem geeigneten Bereich lagen. Falls ja, wird als ausgewählter Messwert SEL_VAL der gemittelte Messwert CH2_AVE des zweiten Kanals ausgewählt.

Ansonsten erfolgt ein Sprung nach S158, und dort wird überprüft, ob alle Einzelmesswerte CH1_VAL des ersten Kanals CH1 im vorgegebenen Bereich lagen. Falls ja, wird als ausgewählter Messwert SEL_VAL der gemittelte Messwert CH1_AVE des ersten Kanals CH1 gewählt.

Ansonsten wird beispielsweise in S162 der ausgewählte Messwert SEL_VAL auf einen Fehlerwert ERR_VAL gesetzt, um einen entsprechenden Fehler anzuzeigen. Alternativ kann derjenige gemittelte Messwert CH1_AVE bzw. CH2_AVE gewählt werden, bei dem das zugeordnete Gütekriterium CH1_OOR bzw. CH2_OOR kleiner ist.

Von S152, S156, S160 oder S162 erfolgt ein Sprung nach S164, und die Routine wird verlassen.

**Fig. 6** zeigt ein Ausführungsbeispiel des Schritts S152 von Fig. 5, in welchem eine Auswahl eines geeigneten gemittelten Messwerts erfolgt, sofern bei beiden Kanälen CH1, CH2 die Einzelmesswerte CH1_VAL, CH2_VAL im vorgegebenen Bereich lagen.

In S170 wird die Differenz zwischen dem gemittelten Messwert CH2_AVE und dem gemittelten Messwert CH1_AVE berechnet. Diese Differenz zeigt betragsmäßig an, ob eine größere Abweichung zwischen den gemittelten Messwerten CH1_VAL und CH2_VAL besteht.

In S172 wird überprüft, ob die Differenz größer ist als ein Differenz-Grenzwert. Falls ja, erfolgt ein Sprung nach S176, und über eine Variable CH_MM, welche auf dem Wert 1 gesetzt wird, wird angezeigt, dass ein signifikanter Unterschied (engl. mismatch) vorliegt. Falls nein, wird in S174 die Variable CH_MM auf den Wert Null gesetzt. In beiden Fällen erfolgt ein Sprung nach S178, und dort wird zum einen überprüft, ob der alte ausgewählte Kanal der erste Kanal ist, und ob der erste gemittelte Messwert CH1_AVE größer ist als ein erster Grenz-Messwert THRESHOLD_HIGH. Falls dies der Fall ist, erfolgt ein Sprung nach S180 und als neuer Kanal CH_NEW wird der zweite Kanal ausgewählt. Es erfolgt ein Sprung nach S186.

Falls nicht, erfolgt ein Sprung nach S182, und dort wird überprüft, ob der bisher ausgewählte Kanal der zweite Kanal CH2 ist, und ob der erste gemittelte Messwert CH1_AVE kleiner ist als ein zweiter Grenz-Messwert THRESHOLD_LOW. Falls dies der Fall ist, erfolgt ein Sprung nach S184, und als neuer Kanal CH_NEW wird der erste Kanal gewählt. Anschließend erfolgt ein Sprung nach S186. Falls die Bedingung in S182 nicht zutrifft, erfolgt direkt ein Sprung nach S186.

In S186 erfolgt in Abhängigkeit von der Variablen CH_NEW ein Sprung nach S188 bzw. S190, und als ausgewählter Messwert SEL_VAL wird entsprechend entweder der gemittelte Messwert CH1_AVE oder der gemittelte Messwert CH2_AVE gewählt. In beiden Fällen erfolgt ein Sprung nach S192, und die Routine wird verlassen.

Die Überprüfung in S178 bzw. S182 kann jeweils auch auf Basis des zweiten gemittelten Messwerts CH2_AVE erfolgen, da beide Messwerte einen entsprechend geeigneten Strombereich angeben.

Durch die beschriebene Messvorrichtung 20 bzw. durch das beschriebene Verfahren konnte im gesamten vorgegebenen Strom-Messbereich und im gesamten vorgegebenen Temperaturbereich eine Messgenauigkeit erzielt werden, die besser als +/- 0,5 % ist. Insbesondere bei niedrigen Strömen (beispielsweise +/- 70 A konnte die Genauigkeit ebenfalls erreicht werden. Die erreichte Messgenauigkeit ist zu vergleichen mit der im Datenblatt des verwendeten Strom-Sensors der Fa. LEM vom Typ DHAB S/133 angegebenen Genauigkeit, welche für den ersten Kanal CH1 mit +/- 1,5 % und für den zweiten Kanal CH2 mit +/- 1,2 % angegeben ist.

Eine solche Messgenauigkeit kann einfacher mit einem Shunt erreicht werden, über welchen der Strom der Leitung 12 von Fig. 1 fließt, wobei zur Strommessung der Spannungsabfall durch den elektrischen Widerstand des Shunts gemessen wird. Diese Messung führt jedoch bei hohen Strömen zu einer hohen elektrischen Verlustleistung und damit ggf. zu Wärmeproblemen und Leistungsverlusten.

Naturgemäß sind im Rahmen der vorliegenden Erfindung vielfältige Abwandlungen und Modifikationen möglich.

## Patentansprüche

1. Verfahren zur Messung eines durch einen Leiter (12) fließenden Stroms (14) mittels einer Messvorrichtung (20),
welche Messvorrichtung (20) einen Stromsensor (30) und mindestens einen A/D-Wandler (39) aufweist, welcher Stromsensor (30) mindestens zwei Kanäle (CH1, CH2) aufweist, über welche Kanäle (CH1, CH2) der Stromsensor (30) jeweils ein den Strom (14) charakterisierendes Messsignal (CH1_SIG, CH2_SIG) liefert, welche mindestens zwei Kanäle (CH1, CH2) einen ersten Kanal (CH1) und einen zweiten Kanal (CH2) umfassen, welcher zweite Kanal (CH2) zur Messung eines größeren Maximalstroms ausgebildet ist als der erste Kanal (CH1),
und welches Verfahren die folgenden Schritte aufweist:
A1) Das Messsignal (CH1_SIG) des ersten Kanals (CH1) wird in einer ersten Signalverarbeitungsvorrichtung (40A) verarbeitet, und es wird ein erster gemittelter Messwert (CH1_AVE) erzeugt,
A2) das Messsignal (CH2_SIG) des zweiten Kanals (CH2) wird in einer zweiten Signalverarbeitungsvorrichtung (40B) verarbeitet, und es wird ein zweiter gemittelter Messwert (CH2_AVE) erzeugt,
wobei in der ersten Signalverarbeitungsvorrichtung (40A) und in der zweiten Signalverarbeitungsvorrichtung (40B) jeweils eine Tiefpassfilterung (41A; 41B) des Messsignals (CH1_SIG; CH2_SIG) durchgeführt wird, eine A/D-Wandlung (42A; 42B) zur Erzeugung digitaler Einzelmesswerte (CH1_VAL; CH2_VAL) durchgeführt wird, eine Beurteilung der Einzelmesswerte (CH1_VAL; CH2_VAL) unter Bildung eines Gütekriteriums (CH1_OOR; CH2_OOR) durchgeführt wird, und eine Mittelung der Einzelmesswerte (CH1_VAL; CH2_VAL) zur Erzeugung eines gemittelten Messwerts (CH1_AVE; CH2_AVE) durchgeführt wird,
B) es wird in einer Auswahlvorrichtung (46) in Abhängigkeit vom jeweiligen Gütekriterium (CH1_OOR; CH2_OOR) ausgewählt, ob der erste gemittelte Messwert (CH2_AVE) oder der zweite gemittelte Messwert (CH2_AVE) als ausgewählter Messwert (SEL_VAL) verwendet wird.

2. Verfahren nach Anspruch 1, bei welchem in der ersten Signalverarbeitungsvorrichtung (40A) und in der zweiten Signalverarbeitungsvorrichtung (40B) jeweils die Einzelmesswerte (CH1_VAL; CH2_VAL) oder die gemittelten Messwerte (CH1_AVE; CH2_AVE) durch eine zugeordnete Korrekturfunktion (44A, f_COR_CH1; 44B, f_COR_CH2) korrigiert werden.

3. Verfahren nach Anspruch 2, bei welchem die Korrekturfunktion (44A, f_COR_CH1; 44B, f_COR_CH2) jeweils abhängig ist vom Ergebnis mindestens einer mit dem zugeordneten Kanal (CH1; CH2) des konkret verwendeten Stromsensors (30) durchgeführten Probemessung.

4. Verfahren nach Anspruch 2 oder 3, bei welchem die Korrekturfunktion (44A; 44B) einen Offset und eine Skalierung umfasst.

5. Verfahren nach einem der vorhergehenden Ansprüche, bei welchem in der Auswahlvorrichtung (46) in Abhängigkeit von der Höhe des ersten gemittelten Messwerts (CH1_AVE) oder der Höhe des zweiten gemittelten Messwerts (CH2_AVE) ausgewählt wird, ob der erste gemittelte Messwert (CH1_AVE) oder der zweite gemittelte Messwert (CH2_AVE) als ausgewählter Messwert (SEL_VAL) verwendet wird.

6. Verfahren nach Anspruch 5,
bei welchem der Übergang von der Verwendung des ersten gemittelten Messwerts (CH1_AVE) als ausgewählter Messwert (SEL_VAL) zu einer Verwendung des zweiten gemittelten Messwerts (CH2_AVE) als ausgewählter Messwert (SEL_VAL) bei einem ersten Grenz-Messwert (THRESHOLD_HIGH) erfolgt,
bei welchem der Übergang von der Verwendung des zweiten gemittelten Messwerts (CH2_AVE) als ausgewählter Messwert (SEL_VAL) zu einer Verwendung des ersten gemittelten Messwerts (CH1_AVE) als ausgewählter Messwert (SEL_VAL) bei einem zweiten Grenz-Messwert (THRESHOLD_LOW) erfolgt,
und bei welchem der erste Grenz-Messwert (THRESHOLD_HIGH) und der zweite Grenz-Messwert (THRESHOLD_LOW) unterschiedlich sind, um eine Hysterese zu bewirken.

7. Verfahren nach Anspruch 6, bei welchem der erste Grenz-Messwert (THRESHOLD_HIGH) einem vom Betrag her höheren Strom (14) entspricht als der zweite Grenz-Messwert (THRESHOLD_LOW).

8. Verfahren nach einem der vorhergehenden Ansprüche, bei welchem die Messvorrichtung (20) einen Temperatursensor (36) aufweist,
bei welchem Verfahren über den Temperatursensor (36) ein Temperatur-Messwert (T_VAL) ermittelt wird und der ausgewählte Messwert (SEL_VAL) in Abhängigkeit von einer vom Temperatur-Messwert (T_VAL) abhängigen Temperatur-Kompensations-Funktion (f_T_COMP) verändert wird, um eine von der aktuellen Temperatur abhängige Beeinflussung des ausgewählten Messwerts (SEL_VAL) zu verringern.

9. Verfahren nach einem der vorhergehenden Ansprüche, bei welchem die Messvorrichtung (20) eine Ausgabevorrichtung (37; 52) aufweist, und bei welchem der ausgewählte Messwert (SEL_VAL) über die Ausgabevorrichtung (37; 52) ausgegeben wird.

10. Verfahren nach Anspruch 9, bei welchem die Ausgabevorrichtung zur Ausgabe des ausgewählten Messwerts (SEL_VAL) über ein Bus-System ausgebildet ist, welches Bus-System bevorzugt als CAN-Bus, LIN-Bus, CAN-FD, FlexRay oder Ethernet mit BroadR-Reach ausgebildet ist.

11. Verfahren nach einem der vorhergehenden Ansprüche, bei welchem bei der Beurteilung der Einzelmesswerte (CH1_VAL; CH2_VAL) unter Bildung des Gütekriteriums (CH1_OOR; CH2_OOR) überprüft wird, ob der jeweilige Einzelmesswert (CH1_VAL; CH2_VAL) vom Betrag her größer ist als ein vorgegebener Maximalwert (CH1_MAX; CH2_MAX), und bei welchem eine Überschreitung des Maximalwerts (CH1_MAX; CH2_MAX) für das Gütekriterium (CH1_OOR; CH2_OOR) gütevermindernd gewertet wird.

12. Verfahren nach einem der vorhergehenden Ansprüche, bei welchem bei der Beurteilung der Einzelmesswerte (CH1_VAL; CH2_VAL) unter Bildung eines Gütekriteriums (CH1_OOR; CH2_OOR) überprüft wird, ob der jeweilige Einzelmesswert (CH1_VAL; CH2_VAL) vom Betrag her kleiner ist als ein vorgegebener Minimalwert, und bei welchem eine Unterschreitung des Minimalwerts für das Gütekriterium (CH1_OOR; CH2_OOR) gütevermindernd gewertet wird.

13. Verfahren nach einem der vorhergehenden Ansprüche, bei welchem der Stromsensor (30) ausgewählt ist aus der Gruppe bestehend aus
- direktabbildender Stromsensor, und
- Kompensations-Stromsensor.

14. Verfahren nach einem der vorhergehenden Ansprüche, bei welchem der Stromsensor (30) dazu ausgebildet ist, die durch den zu messenden Strom erzeugte magnetische Flussdichte zu messen.

15. Messvorrichtung (20), welche einen Stromsensor (30) und mindestens einen A/D-Wandler aufweist, welcher Stromsensor (30) mindestens zwei Kanäle (CH1, CH2) aufweist, über welche Kanäle (CH1, CH2) der Stromsensor (30) jeweils ein den Strom (14) charakterisierendes Messsignal (CH1_SIG, CH2_SIG) liefert, welche mindestens zwei Kanäle (CH1, CH2) einen ersten Kanal (CH1) und einen zweiten Kanal (CH2) umfassen, welcher zweite Kanal (CH2) zur Messung eines größeren Maximalstroms ausgebildet ist als der erste Kanal (CH1), und welche Messvorrichtung (20) dazu ausgebildet ist, ein Verfahren nach einem der vorhergehenden Ansprüche auszuführen.
